# EUROPÄISCHE PATENTSCHRIFT

(11) **EP 0 909 462 B1**
(45) Veröffentlichungstag und Bekanntmachung des Hinweises auf die Patenterteilung: **12.02.2003**
(21) Anmeldenummer: 97925843.1
(22) Anmeldetag: 07.05.1997
(51) Int. Cl.: H01L 25/07, H01L 25/065, H01L 23/427

(54) **ANORDNUNG ZUR WÄRMEABLEITUNG BEI CHIPMODULEN AUF MEHRSCHICHT-KERAMIKTRÄGERN, INSBESONDERE MULTICHIPMODULE**
ARRANGEMENT FOR HEAT DISSIPATION IN CHIP MODULES ON MULTILAYERED CERAMIC CARRIERS, IN PARTICULAR MULTICHIP MODULES
SYSTEME DE DISSIPATION DE CHALEUR POUR DES MODULES DE PUCES SUR DES SUPPORTS CERAMIQUES A COUCHES MULTIPLES, NOTAMMENT DES MODULES MULTIPUCES

(30) Priorität: 29.06.1996 DE 19626227
(43) Veröffentlichungstag der Anmeldung: 21.04.1999
(73) Patentinhaber: ROBERT BOSCH GMBH, 70442 Stuttgart (DE)
(72) Erfinder: STECHER, Guenther, D-71229 Leonberg (DE); SEIBOLD, Annette, D-71277 Rutesheim (DE)
(86) Internationale Anmeldenummer: DE9700923
(87) Internationale Veröffentlichungsnummer: WO98000869

(56) Entgegenhaltungen:
- EP-A- 0 251 836
- DE-A- 3 402 003
- US-A- 4 880 053
- US-A- 5 527 588

## Beschreibung

### Stand der Technik

Die Erfindung geht aus von einer Anordnung zur Wärmeableitung bei Chipmodulen, wie sie aus der DE-A 3 402 003 bekannt ist. Diese Druckschrift beschreibt ein Leistungshalbleitermodul, bei dem zur Verbesserung der Abfuhr der Verlustwärme von Leistungshalbleiterbauelementen aus Leistungshalbleitermodulen mindestens ein Wärmerohr in das Modul integriert ist, wobei das Wärmerohr mit Kapillaren für den Flüssigkeitsrücktransport versehen werden kann. Dieses bekannte Halbleitermodul enthält jedoch im Bereich des aufzubringenden Chips keinen als Verdampfungsraum wirkenden Hohlraum unterhalb von thermischen Durchlässen eines Mehrschicht-Keramikträgers, es besitzt weiterhin keinen Kühlkörper mit einer Aussparung, sowie keine Dampfkanäle und Kapillaren, die den Hohlraum mit der Aussparung verbinden. Stattdessen wird bei der bekannten Ausführung nach der DE-A 3 402 003 ein Substrat aus metallisierter Keramik verwendet mit einem in dem Leistungshalbleitermodul integrierten Wärmerohr, wobei die abzuführende Wärme auf eine vergrößerte Fläche des Wärmerohres zwecks Kondensation verteilt wird.

Bei einer anderen bekannten Anordnung zur Wärmeableitung bei Modulen, bei denen ein oder mehrere Chips auf einem Mehrschicht-Keramikträger angeordnet sind, wird das oder werden die Chips, insbesondere der oder die Leistungs-IC's, auf sogenannten "Thermal vias", thermischen Durchlässen, angeordnet. Diese thermischen Durchlässe sind eine regelmäßige Anordnung von Löchern, Locharrays, die in allen Schaltungslagen gestanzt sind und mit Silberpaste gefüllt werden. Die Wärmeabfuhr von den Leistungs-IC's durch die thermischen Durchlässe hindurch zu der metallischen Grundplatte, die unter dem Mehrschicht-Keramikträger angeordnet ist, ist nicht sehr effektiv. Durch die durch alle Schaltungslagen hindurch gestanzten Durchlässe wird viel Fläche verbraucht, die für andere Leitungsbahnen auf den entsprechenden Schaltungslagen verloren ist. Dadurch nimmt die Schaltungsdichte ab.

Die von der Firma IBM entwickelte, bekannte technische Lösung der thermisch leitenden Module, TCM (thermal conductive moduls), führt die Wärmeleistung der IC's sehr effektiv senkrecht nach oben vom Substrat ab. Diese Lösung ist für viele Anwendungen jedoch zu aufwendig.

Generell sei angemerkt, daß Heatpipe-Strukturen Vorrichtungen sind, die zur Abfuhr von Wärmemengen dienen, von einem Ort der Erzeugung zu einem anderen. Bei entsprechender Auslegung ist ihr effektiver Wärmetransport um 10er Faktoren höher als der von besten metallischen Wärmeleitern. Eine gute Beschreibung ihrer Wirkung wird beispielsweise von Y. Eastman in Scientific American, 5/68, Seite 38 - 46, gegeben.

Das Prinzip der heatpipes läßt sich wie folgt beschreiben: am heißen Bereich der Anordnung verdampft eine geeignete Flüssigkeit mit hoher latenter Verdampfungswärme. Der bei der Verdampfung entstehende Druck treibt den Dampf zum kalten Teil der Anordnung. Dort kondensiert der Dampf in die flüssige Phase und gibt die transportierte Wärme wieder ab. Das flüssige Kondensat wird wieder zur Verdampfungsstelle zurückgeführt. Damit ist ein Kreislauf aufgebaut.

### Vorteile der Erfindung

Die erfindungsgemäße Anordnung zur Wärmeableitung bei Chipmodulen gemäß dem Anspruch 1 hat gegenüber den bekannten Anordnungen den Vorteil, daß das Prinzip der heatpipes in miniaturisierter Form zur effektiven Kühlung von Leistungs-IC's, die auf relativ schlecht leitenden Mehrschicht-Keramikträgern, insbesondere Glaskeramik-Mehrlagenschaltungen, aufgebracht sind, angewandt wird. Die Wärme wird wesentlich effektiver zur metallischen Wärmesenke abgeführt, wobei Schaltungsdichte und Schaltungsflexibilität erhalten bleiben, da der notwendige Flächenverbrauch minimiert ist.

Gemäß der Erfindung wird dies prinzipiell dadurch erreicht, daß der Mehrschicht-Keramikträger auf einem metallischen Kühlkörper aufgebracht ist, in der obersten Lage des Mehrschicht-Keramikträgers im Bereich des aufzubringenden Chips thermische Durchlässe, insbesondere in Form eines Lochmusters oder Arrays vorgesehen sind, in der darunter befindlichen nächsten Lage des Mehrschicht-Keramikträgers im Bereich des aufzubringenden Chips ein als Verdampfungsraum wirkender Hohlraum vorgesehen ist, im metallischen Kühlkörper im Bereich des aufzubringenden Chips eine wannenähnliche Aussparung, die als Kondensor wirkt, vorgesehen ist, und die Lagen des Mehrschicht-Keramikträgers, die zwischen dem Verdampfungsraum und dem Kondensor liegen, im Bereich dieser Räume mit einer ganzen Anzahl von großflächigen Dampfkanälen und kleinflächigen, als Kapillaren wirkenden Kondensatkanälen versehen sind, welche die beiden Räume miteinander verbinden.

Der Anspruch 13 definiert ein Herstellungsverfahren einer Anordnung gemäß dem Anspruch 5.

Durch die in den weiteren Ansprüchen niedergelegten Maßnahmen sind vorteilhafte Weiterbildungen und Verbesserungen der im Anspruch 1 angegebenen Anordnung zur Wärmeableitung möglich.

Entsprechend einer vorteilhaften Ausgestaltung der Erfindung sind auf dem Mehrschicht-Keramikträger eine Vielzahl von Chips, insbesondere erhebliche Verlustwärme erzeugende Leistungs-ICs, aufbringbar.

Gemäß einer weiteren vorteilhaften Ausgestaltung der Erfindung ist jede in dem Mehrschicht-Keramikträger vorgesehene als Kondensor wirkende wannenförmige Ausnehmung mit einer verschließbaren Füllöffnung zum Einfüllen eines Wärme leitenden Mediums versehen.

Entsprechend einer besonders vorteilhaften und einfach herzustellenden Ausführungsform der Erfindung sind die großflächigen Dampfkanäle und die kleinflächigen Kondensatkanäle als gerade Kanäle zwischen den zugehörigen Schichten des Mehrschicht-Keramikträgers ausgeführt.

Gemäß einer zu dieser Ausführungsform alternativen Gestaltungsform der Erfindung, die bei manchen Anwendungen insbesondere im Hinblick auf den Flächenbedarf sowie die Anordnung von Leitungen interessant ist, sind die kleinflächigen Kondensatkanäle zumindest zum Teil als abgewinkelte Kanäle ausgebildet, von denen zumindest ein Teilbereich in der Ebene einer oder mehrerer Lagen des Mehrschicht-Keramikträgers verläuft. Die in der Ebene einer oder mehrerer Lagen verlaufenden Teil der Kondensatkanäle können auf verschiedene Weise hergestellt werden. So können sie durch Drucken hergestellt werden, wobei die entsprechenden Teile der Kanäle mit Kohlepaste gedruckt werden, welche später zur Erzeugung der Teilkanäle ausgebrannt wird, oder sie können durch Ausstanzen oder Ausfräsen oder durch Prägen der Teile der Kanäle in dem ungebrannten Keramikmaterial, insbesondere dem Keramiktape, hergestellt werden.

In vorteilhafter Weiterbildung der Erfindung weisen die großflächigen Dampfkanäle einen Durchmesser von ca. 1,5 mm und die kleinflächigen Kondensatkanäle einen Durchmesser von ca. 0,1 mm auf.

In weiterer zweckmäßiger Ausgestaltung der Erfindung, die zur Verbesserung der Kondensatleitung beitragen kann, sind die kleinflächigen Kondensatkanäle mit porösem Keramikpulver oder mit bei den verwendeten Brenntemperaturen nicht sinternden metallischen Fritten gefüllt.

Um direktes Verdampfen des Kondensats zu verhindern, können gemäß einer weiteren vorteilhaften Ausgestaltung der Erfindung die großflächigen Dampfkanäle im Bereich des im metallischen Kühlkörper vorgesehenen Kondensorraums einen Durchmesser bzw. eine Durchlaßfläche aufweisen, die geringer ist als die in weiter entfernten Schichten des Mehrschicht-Keramikträgers vorgesehene Durchlaßfläche des Dampfkanals.

In zweckmäßiger Ausführung der Erfindung ist als Wärme leitende Arbeitsflüssigkeit eine Flüssigkeit mit möglichst hoher Verdampfungswärme bei geeigneter Verdampfungstemperatur, sowie mit hoher Oberflächenspannung und Benetzungswinkel für die Kapillaren, vorgesehen, insbesondere Alkohole und Kohlenwasserstoffe.

Bei der Erfindung ist in weiterer vorteilhafter Ausgestaltung vorgesehen, daß der oder die einzelnen Chips durch einen geeigneten, Wärme leitenden Klebstoff auf dem Mehrschicht-Keramikträger befestigbar ist bzw. sind, und/oder daß der Mehrschicht-Keramikträger durch einen geeigneten, Wärme leitenden Klebstoff auf dem metallischen Kühlkörper befestigbar ist.

### Zeichnung

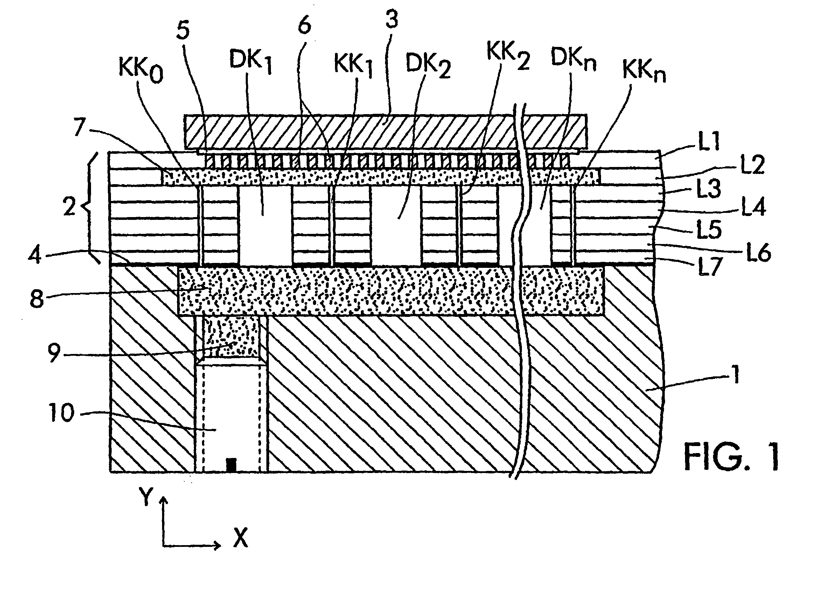

Die Erfindung ist anhand eines in der Zeichnung dargestellten Ausführungsbeispiels in der nachfolgenden Beschreibung näher erläutert. Die einzige Figur zeigt schematisch in einem Schnittbild in der x-y-Ebene einen Ausschnitt aus einem Mehrschicht-Keramikträger, der auf einem metallischen Kühlkörper aufgebracht ist, und auf den selbst ein Chip bzw. ein Leistungs-IC montiert ist.

### Beschreibung des Ausführungsbeispiels

In der Figur ist in einem Schnittbild durch eine Anordnung von einem metallischem Kühlkörper 1, einem Mehrschicht-Keramikträger 2 und einem darauf montiertem Chip 3 die Erfindung schematisch dargestellt. Die Darstellung ist nicht unbedingt maßstabsgerecht. So sind die Dimensionen in x-Richtung etwa 10-fach und die Dimensionen in y-Richtung etwa 40-fach vergrößert dargestellt, um die erfindungswesentlichen Merkmale gut erkennbar zu zeigen. Weiterhin sind die elektrischen Verbindungen des Chips 3 mit der Schaltung über Bonddrähte sowie auch die elektrischen Bahnen innerhalb der einzelnen Lagen des Mehrschicht-Keramikträgers 2 nicht dargestellt.

Der im dargestellten Beispiel aus sieben Lagen bzw. Schichten L1 bis L7 bestehende Mehrschicht-Keramikträger 2 ist mittels einer Kleblage 4 auf dem metallischen Kühlkörper 1 befestigt. Der Chip 3, der einen Leistungs-IC, eine relativ viel Verlustwärme erzeugende integrierte Schaltung darstellt, und dessen erzeugte Verlustwärme abzuleiten ist, ist ebenfalls mittels einer Klebschicht 5 befestigt, und zwar auf der obersten Lage L1 des Mehrschicht-Keramikträgers 2. Der oder die für die klebenden Schichten 4 und 5 verwendeten Klebstoffe sind wärmeleitend.

In der obersten Lage L1 des Mehrschicht-Keramikträgers 2 sind im Bereich des aufzubringenden Chips 3, etwa in dessen flächiger Größenausdehnung, eine Reihe von thermischen Durchlässen 6 vorgesehen. Diese Durchlässe 6 können als thermische Vias bezeichnet werden und sind beispielsweise durch Ausstanzen der Lage 1 in Form eines regelmäßigen Lochmusters, eines Locharrays, herzustellen. Nach dem Stanzen oder Bohren dieser als Durchlässe 6 dienenden Bohrungen werden sie zur besseren Wärmeleitung beispielsweise mit Silberpaste gefüllt. Die Bohrungen bzw. Durchlässe 6 können einen Durchmesser von ca. 0,2 mm und einen gleich großen Zwischenraum haben.

In der darunter befindlichen nächsten Lage L2 des Mehrschicht-Keramikträgers 2 ist ein Hohlraum 7 vorgesehen. Dieser Hohlraum 7 ist ausdehnungsmäßig größer als das darüber befindliche Lochmuster. Vorzugsweise ist es auch größer als der zu montierende Chip 3. Dies ist in der Figur dargestellt. Der Hohlraum 7 kann durch Ausstanzen der Lage L2 in der notwendigen Größe auf einfache Weise gebildet werden. Der Hohlraum 7 bildet unterhalb des Chips 3 und somit sehr nahe an der Wärmequelle, einen Verdampfungsraum. Dieser Verdampfungsraum steht durch die Vielzahl von Durchlässen 6 in intensiver Wärmekopplung mit dem Chip 3.

Der metallische Kühlkörper 1 ist erfindungsgemäß im Bereich des aufzubringenden Chips 3 mit einer wannenähnlichen Aussparung 8 an der dem Mehrschicht-Keramikträger 2 zugewandten Seite versehen. Die flächenmäßige Ausdehnung dieser Aussparung 8 entspricht in etwa derjenigen des zugehörigen, darüber anzuordnenden Chips 3. Sie kann auch, wie in der Figur dargestellt, geringfügig größer sein. Die wannenähnliche Aussparung 8 im metallischen Kühlkörper bildet den Kondensor. In diesem Raum wird aus der verdampften Arbeitsflüssigkeit wieder die flüssige Arbeitsflüssigkeit.

In denjenigen Lagen, im in der Figur dargestellten Beispiel sind dies die Lagen L3 - L7, des Mehrschicht-Keramikträgers 2, die zwischen dem den Verdampfungsraum bildenden Hohlraum 7 in Lage L2 und der den Kondensor bildenden wannenähnliche Aussparung 8 im Kühlkörper 1 liegen, sind gemäß einem wesentlichen Merkmal der Erfindung eine Anzahl von großflächigen Dampfkanälen DK1 - DKn und kleinflächigen, als Kapillaren wirkende Kondensatkanäle KK0 - KKn angebracht. Diese Dampfkanäle DK1 - DKn und diese Kondensatkanäle KK0 - KKn sind im Bereich der Räume 7 und 8 angeordnet und verbinden diese beiden Räume miteinander. In dem in der Figur dargestellten Ausführungsbeispiel sind die großflächigen Dampfkanäle DK1 - DKn mit einem Durchmesser von etwa 1,5 mm gezeigt, und die kleinflächigen Kondensatkanäle KK0 - KKn mit einem Durchmesser von ca. 0,1 mm.

In weiterer Ausgestaltung der Erfindung ist die wannenähnliche Ausnehmung 8 im Kühlkörper 1, die durch Ausfräsen hergestellt werden kann, mit einer Füllöffnung 9 versehen, die durch eine Schraube 10 verschließbar ist. Durch diese Füllöffnung 9, die auf der der Ausnehmung 8 gegenüberliegenden Seite des Kühlkörpers 1 angeordnet ist, wird nach Montage des Chips 3 das wärmeleitende Medium, die verdampfende und wieder kondensierende Arbeitsflüssigkeit eingefüllt. Nach Verschließen der Füllöffnung 9 durch die Schraube 10 kann der Betrieb aufgenommen werden. Als Wärme leitende Arbeitsflüssigkeit wird in vorteilhafter Weise eine Flüssigkeit mit möglichst hoher Verdampfungswärme bei geeigneter Verdampfungstemperatur verwendet, die mit hoher Oberflächenspannung und Benetzungswinkel für die Kapillaren versehen ist. Dies können insbesondere Alkohole und Kohlenwasserstoffe sein.

Im in der Figur dargestellten Ausführungsbeispiel sind sowohl die großflächigen Dampfkanäle DK1 - DKn als auch die kleinflächigen Kondensatkanäle KK0 - KKn als gerade Kanäle zwischen den zugehörigen Schichten bzw. Lagen L3 und L7 des Mehrschicht-Keramikträgers 2 ausgeführt. Alternativ dazu ist es möglich, die Dampfkanäle DK1 - DKn in der untersten Lage L7 mit kleinerem Durchmesser als in den anderen Lagen L6 - L3 zu versehen, um eine direkte Verdampfung von Kondensat zu verhindern. Es ist auch möglich, zumindest einige der kleinflächigen Kondensatkanäle KK0 - KKn statt als gerade Kanäle zumindest in Teilbereichen davon abweichend mit horizontalen Strecken, die in der Ebene von Schichten, d. h. innerhalb von Lagen des Mehrschicht-Keramikträgers 2 verlaufen, zu versehen. Diese das Kondensat zu dem Verdampfungsraum führende Kapillarkanäle werden dann teilweise in der Schichtlage ausgeführt. Auch eine Kombination von geraden und abgewinkelten Kondensatkanälen ist möglich. Dadurch ist eine besonders flexible Anpassungsmöglichkeit an Schaltungsnotwendigkeiten und Platzverhältnisse in einzelnen oder mehreren Lagen eröffnet.

Die Kapillarkanäle, die teilweise in einer Schichtlage ausgeführt sind, können nach einer möglichen Ausführungsform durch Drucken hergestellt werden. Dabei werden die Kanäle mit Kohlepaste gedruckt, welche später zur Erzeugung der Kanäle ausgebrannt wird. Andere Möglichkeiten der Herstellung bestehen im Ausstanzen, im Ausfräsen der Kanäle. Eine besonders zweckmäßige Möglichkeit besteht im Prägen der Kanäle in dem ungebrannten Keramikmaterial, insbesondere dem Keramiktape.

Gemäß einer Ausgestaltung der Erfindung können die als Kapillarkanäle dienenden Bohrungen KK0 - KKn, die Kondensatkanäle, statt leer zu sein auch mit geeignetem Material gefüllt sein. Beispielsweise kann poröses Keramikpulver oder bei den verwendeten Brenntemperaturen von ca. 900°C nicht sinternde metallische Fritten eingesetzt werden. Dadurch wird der besondere Vorteil erzielt, daß die Kapillarkräfte beeinflußt werden können. Es kann somit der Durchmesser der kleinflächigen Kondensatkanäle KK0 - KKn größer gestaltet und damit die Durchsaugmenge des Kondensats erhöht werden.

Die in der Figur für ein Chip 3 dargestellte Anordnung zur Wärmeableitung ist dann von besonderem Vorteil, wenn mehrere Chips 3 auf ein und demselben Mehrschicht-Keramikträger 2 und dieser wiederum auf einem Kühlkörper 1 montiert sind. Dann besonders ist die gewonnene Schaltungsdichte und Effektivität der Wärmeableitung von enormem Vorteil. Die erfindungsgemäß geschaffene miniaturisierte Heatpipe-Struktur erlaubt also bei erhöhter Wärmeabfuhr eine wesentlich größere Schaltungsdichte und Flexibilität in der Gestaltung der Schaltung. Die erfindungsgemäß gestaltete Anordnung stellt einen effektiven Wärme ableitenden Kreislauf sicher, welcher in miniaturisierter Ausführung bei kurzen Wegen viel Energie pro Zeiteinheit transportieren kann.

## Patentansprüche

1. Anordnung zur Wärmeableitung bei Chipmodulen auf Mehrschicht-Keramikträgern, wobei im Keramikträger Durchlässe für eine Wärme leitende, verdampfbare Arbeitsflüssigkeit vorgesehen sind, **dadurch gekennzeichnet, daß** der Mehrschicht-Keramikträger (2) auf einem metallischen Kühlkörper (1) aufgebracht ist, daß in der obersten Lage (L1) des Mehrschicht-Keramikträgers (2) im Bereich des aufzubringenden Chips (3) thermische Durchlässe (6) vorgesehen sind, daß in der darunter befindlichen nächsten Lage (L2) des Mehrschicht-Keramikträgers (2) im Bereich des aufzubringenden Chips (3) ein als Verdampfungsraum wirkender Hohlraum (7) vorgesehen ist, daß im metallischen Kühlkörper (1) im Bereich des aufzubringenden Chips (3) eine wannenähnliche Aussparung (8), die als Kondensor wirkt, vorgesehen ist, daß die Lagen (L3 - L7) des Mehrschicht-Keramikträgers (2), die zwischen dem Hohlraum (7) und dem Kondensor (8) liegen, mit einer Mehrzahl von großflächigen Dampfkanälen (DK1 - DKn) und kleinflächigen, als Kapillaren wirkenden Kondensatkanälen (KK0 - KKn) versehen sind, welche dem Hohlraum und den Kondensor miteinander verbinden.

2. Anordnung nach Anspruch 1, **dadurch gekennzeichnet, daß** auf dem Mehrschicht-Keramikträger (2) eine Vielzahl von Chips (3) aufbringbar ist.

3. Anordnung nach Anspruch 1 oder 2, **dadurch gekennzeichnet, daß** jede in dem Mehrschicht-Keramikträger (2) vorgesehene, als Kondensor wirkende wannenförmige Ausnehmung (8) mit einer verschließbaren Füllöffnung (9, 10) zum Einfüllen einer Wärme leitenden Arbeitsflüssigkeit versehen ist.

4. Anordnung nach einem der vorigen Ansprüche, **dadurch gekennzeichnet, daß** die großflächigen Dampfkanäle (DK1 - DKn) und die kleinflächigen Kondensatkanäle (KK0 - KKn) als gerade Kanäle zwischen den zugehörigen Schichten (L3 - L7) des Mehrschicht-Keramikträgers (2) ausgeführt sind.

5. Anordnung nach einem der Ansprüche 1-3, **dadurch gekennzeichnet, daß** von den kleinflächigen Kondensatkanälen (KK0 - KKn) zumindest einige als abgewinkelte Kanäle ausgebildet sind, von denen zumindest ein Teilbereich in der Ebene einer oder mehrerer Lagen (L3 - L7) des Mehrschicht-Keramikträgers (2) verläuft.

6. Anordnung nach einem der vorigen Ansprüche, **dadurch gekennzeichnet, daß** die großflächigen Dampfkanäle (DK1 - DKn) einen Durchmesser von ca. 1,5mm und die kleinflächigen Kondensatkanäle (KK0 - KKn) einen Durchmesser von ca. 0,1mm aufweisen.

7. Anordnung nach einem der vorigen Ansprüche, **dadurch gekennzeichnet, daß** die kleinflächigen Kondensatkanäle (KK0 - KKn) mit porösem Keramikpulver oder mit bei den verwendeten Brenntemperaturen nicht sinternden metallischen Fritten gefüllt sind.

8. Anordnung nach einem der vorigen Ansprüche, **dadurch gekennzeichnet, daß** die großflächigen Dampfkanäle (DK1 - DKn) im Bereich des im metallischen Kühlkörper (1) vorgesehenen Kondensorraums (8) einen Durchmesser beziehungsweise eine Durchlaßfläche aufweisen, die geringer ist als die in weiter entfernten Schichten (L6 - L3) des Mehrschicht-Keramikträgers (2) vorgesehene Durchlaßfläche des Dampfkanals.

9. Anordnung nach einem der vorigen Ansprüche, **dadurch gekennzeichnet, daß** als Wärme leitende Arbeitsflüssigkeit eine Flüssigkeit mit möglichst hoher Verdampfungswärme bei geeigneter Verdampfungstemperatur, sowie mit hoher Oberflächenspannung und Benetzungswinkel für die Kapillaren, vorgesehen ist.

10. Anordnung nach einem der vorigen Ansprüche, **dadurch gekennzeichnet, daß** der oder die einzelnen Chips (3) durch einen geeigneten, Wärme leitenden Klebstoff (5) auf dem Mehrschicht-Keramikträger (2) befestigbar ist und/oder daß der Mehrschicht-Keramikträger (2) durch einen geeigneten Wärme, leitenden Klebstoff (4) auf dem metallischen Kühlkörper (1) befestigbar ist.

11. Anordnung nach einem der vorigen Ansprüche, **dadurch gekennzeichnet, daß** die thermischen Durchlässe (6) die Form eines Lochmusters oder Arrays besitzen.

12. Anordnung nach einem der vorigen Ansprüche, **dadurch gekennzeichnet, daß** als Wärme leitende Arbeitsflüssigkeiten Alkohole und Kohlenwasserstoffe dienen.

13. Verfahren zur Herstellung einer Anordnung nach Anspruch 5, **dadurch gekennzeichnet, daß** die in der Ebene einer Lage verlaufenden Teile der Kondensatkanäle (KK0 - KKn) durch Drucken hergestellt werden, wobei die entsprechenden Teile der Kanäle mit Kohlepaste gedruckt werden, welche später zur Erzeugung der Teilkanäle ausgebrannt wird, oder durch Ausstanzen oder Ausfräsen oder durch Prägen der Teile der Kanäle in dem ungebrannten Keramikmaterial.

## Claims

1. Arrangement for heat dissipation in chip modules on multi-layered ceramic carriers, passages for a heat-conducting, vaporizable working fluid being provided in the ceramic carrier, **characterized in that** the multi-layered ceramic carrier (2) is applied to a metallic heat sink (1), **in that** thermal passages (6) are provided in the uppermost layer (L1) of the multi-layered ceramic carrier (2) in the region of the chip (3) to be applied, **in that** a cavity (7) acting as a vaporizing space is provided in the next layer (L2) thereunder of the multi-layered ceramic carrier (2) in the region of the chip (3) to be applied, **in that** a trough-like recess (8), which acts as a condenser, is provided in the metallic heat sink (1) in the region of the chip (3) to be applied, and **in that** the layers (L3 - L7) of the multi-layered ceramic carrier (2) which lie between the cavity (7) and the condenser (8) are provided with a plurality of large-area vapour channels (DK1 - DKn) and small-area condensate channels (KK0 - KKn), acting as capillaries, which connect the cavity and the condenser to each other.

2. Arrangement according to Claim 1, **characterized in that** a multiplicity of chips (3) can be applied to the multi-layered ceramic carrier (2).

3. Arrangement according to Claim 1 or 2, **characterized in that** each trough-shaped recess (8) provided in the multi-layered ceramic carrier (2) and acting as a condenser is provided with a closable filling opening (9, 10) for introducing a heat-conducting working fluid.

4. Arrangement according to one of the above claims, **characterized in that** the large-area vapour channels (DK1 - DKn) and the small-area condensate channels (KK0 - KKn) are formed as straight channels between the associated layers (L3 - L7) of the multi-layered ceramic carrier (2).

5. Arrangement according to one of Claims 1-3, **characterized in that**, of the small-area condensate channels (KK0 - KKn), at least some are formed as angled-away channels, of which at least a partial region runs in the plane of one or more layers (L3 - L7) of the multi-layered ceramic carrier (2).

6. Arrangement according to one of the above claims, **characterized in that** the large-area vapour channels (DK1 - DKn) have a diameter of about 1.5 mm and the small-area condensate channels (KK0 - KKn) have a diameter of about 0.1 mm.

7. Arrangement according to one of the above claims, **characterized in that** the small-area condensate channels (KK0 - KKn) are filled with porous ceramic powder or with metallic frits which do not sinter at the combustion temperatures used.

8. Arrangement according to one of the above claims, **characterized in that** the large-area vapour channels (DK1 - DKn) have in the region of the condenser space (8) provided in the metallic heat sink (1) a diameter or a passage area which is smaller than the passage area of the vapour channel provided in more remote layers (L6 - L3) of the multi-layered ceramic carrier (2).

9. Arrangement according to one of the above claims, **characterized in that** a fluid with the greatest possible heat of evaporation at a suitable vaporizing temperature, and also with a high surface tension and wetting angle for the capillaries is provided as the heat-conducting working fluid.

10. Arrangement according to one of the above claims, **characterized in that** the individual chip or chips (3) can be attached on the multi-layered ceramic carrier (2) by a suitable heat-conducting adhesive (5) and/or **in that** the multi-layered ceramic carrier (2) can be attached on the metallic heat sink (1) by a suitable heat-conducting adhesive (4).

11. Arrangement according to one of the above claims, **characterized in that** the thermal passages (6) have the form of a pattern of holes or an array.

12. Arrangement according to one of the above claims, **characterized in that** alcohols and hydrocarbons serve as heat-conducting working fluids.

13. Method of producing an arrangement according to Claim 5, **characterized in that** the parts of the condensate channels (KK0 - KKn) running in the plane of a layer are produced by printing, the corresponding parts of the channels being printed with carbon paste, which is later burnt out to produce the part-channels, or by punching out or milling out or by stamping the parts of the channels in the unsintered ceramic material.

## Revendications

1. Système de dissipation de chaleur pour des modules de puces sur des supports céramiques à couches multiples, le support céramique ayant des passages prévus pour un liquide opératoire évaporable conducteur de chaleur,
**caractérisé en ce que**
le support céramique à couches multiples (2) est appliqué sur un dissipateur thermique (1) métallique, avec dans la couche supérieure (L1) du support céramique à couches multiples (2) des passages thermiques (6) prévus dans la zone de la puce (3) à appliquer, dans la couche (L2) située immédiatement au-dessous du support céramique à couches multiples (2) on prévoit dans la zone de la puce (3) à appliquer un espace vide (7) qui sert d'espace de vaporisation, dans le dissipateur thermique (1) métallique, on prévoit dans la zone de la puce à appliquer (3) un évidement (8) en forme de cuvette qui sert de condenseur, les couches (L3 - L7) du support céramique à couches multiples (2) qui se trouvent entre l'espace creux (7) et le condenseur (8) sont munies d'un grand nombre de canaux de vapeur (DK1 - DKn) à grande surface et de canaux de condensat (KK0- KKn) à petites surface qui agissent en tant que capillaires qui relient l'un à l'autre l'espace creux et le condenseur.

2. Système selon la revendication 1,
**caractérisé en ce que**
l'on peut appliquer un grand nombre de puces (3) sur le support céramique à couches multiples (2).

3. Système selon la revendication 1 ou 2,
**caractérisé en ce que**
chaque évidement en forme de cuvette (8), agissant comme condenseur, prévu dans le support céramique à couches multiples (2) est muni d'une ouverture de remplissage (9, 10) susceptible d'être fermée pour verser un liquide opératoire conducteur de chaleur.

4. Système selon l'une des revendications précédentes,
**caractérisé en ce que**
les canaux de vapeur (DK1 - DKn) à grande surface et les canaux de condensat (KK0- KKn) à petite surface sont réalisés en tant que canaux droits entre les couches (L3 - L7) correspondantes du support céramique à couches multiples (2).

5. Système selon l'une des revendications 1 à 3,
**caractérisé en ce que**
les canaux de condensat (KK0- KKn) à petite surface sont formés au moins pour certains en tant que canaux recourbés, desquels au moins une zone partielle s'étend dans le plan d'une ou de plusieurs couches (L3 - L7) du support céramique à couches multiples (2).

6. Système selon l'une des revendications précédentes
**caractérisé en ce que**
les canaux de vapeur (DK1 - DKn) à grande surface ont un diamètre d'environ 1,5 mm et les canaux de condensat (KK0- KKn) à petite surface un diamètre d'environ 0,1 mm.

7. Système selon l'une des revendications précédentes,
**caractérisé en ce que**
les canaux de condensat (KK0- KKn) à petite surface sont remplis d'une poudre céramique poreuse ou de frittes métalliques qui ne se vitrifient pas aux températures de cuisson utilisées.

8. Système selon l'une des revendications précédentes,
**caractérisé en ce que**
les canaux de vapeur (DK1 - DKn) à grande surface dans la zone de l'espace du condenseur (8) prévue dans le dissipateur thermique (1) métallique présentent un diamètre ou une surface de passage qui est inférieure à la surface de passage du canal de vapeur prévue dans les couches (L3 - L7) plus éloignées du support céramique à couches multiples (2).

9. Système selon l'une des revendications précédentes,
**caractérisé en ce que**
l'on prévoit en tant que liquide opératoire conducteur de chaleur un liquide avec une chaleur de vaporisation la plus élevée possible pour une température de vaporisation adaptée ainsi qu'avec une tension de surface et un angle de mouillage élevés pour les capillaires.

10. Système selon l'une des revendications précédentes,
**caractérisé en ce que**
la ou les puces (3) particulière peut être fixée sur le support céramique à couches multiples (2) par une substance collante (5) conductrice de chaleur adaptée et/ou le support céramique à couches multiples (2) peut être fixé sur le dissipateur thermique (1) métallique par une substance collante (4) adaptée conductrice de chaleur.

11. Système selon l'une des revendications précédentes,
**caractérisé en ce que**
les passages thermiques (6) possèdent la forme d'un modèle de trous ou d'un arrangement.

12. Système selon l'une des revendications précédentes,
**caractérisé en ce que**
des alcools et des hydrocarbures servent de liquides opératoires conducteurs de chaleur.

13. Procédé pour fabriquer un système selon la revendication 5,
**caractérisé en ce que**
les parties des canaux de condensat (KK0 - KKn) qui s'étendent dans le plan d'une couche sont fabriqués par pression, les parties correspondantes des canaux étant pressées avec de la pâte de carbone qui ensuite est brûlée pour fabriquer les canaux partiels, ou par matriçage ou par fraisage ou par estampage des parties des canaux dans le matériau céramique non brûlé.
